Europäisches Patentamt

European Patent Office

Office européen des brevets

(11) Veröffentlichungsnummer: **0 218 858**
**B1**

(12) **EUROPÄISCHE PATENTSCHRIFT**

(45) Veröffentlichungstag der Patentschrift:
**14.02.90**

(21) Anmeldenummer: **86111721.6**

(22) Anmeldetag: **25.08.86**

(51) Int. Cl.⁴: **H01L 31/02**, H01L 25/04,
B64G 1/44

(54) Sonnenenergiesammler zur Erzeugung elektrischer Energie aus Sonnenstrahlen.

(30) Priorität: **11.10.85 DE 3536290**

(43) Veröffentlichungstag der Anmeldung:
**22.04.87 Patentblatt 87/17**

(45) Bekanntmachung des Hinweises auf die Patenterteilung:
**14.02.90 Patentblatt 90/7**

(84) Benannte Vertragsstaaten:
**FR GB IT NL**

(56) Entgegenhaltungen:
**EP-A- 0 028 820**
**EP-A- 0 062 399**
**DE-A- 2 557 296**
**FR-A- 2 546 337**
**US-A- 4 143 640**
**US-A- 4 220 137**
**US-A- 4 228 789**
**US-A- 4 421 098**

**ELECTRONICS INTERNATIONAL, Band 41, Nr. 24, 25. November 1968, Seiten 5E,6E, New York, US: "Thin solar cells"**
**14th IEEE PHOTOVOLTAIC SPECIALISTS CONFERENCE-1980, San Diego, California, US, 7.-10. Januar 1980, Seiten 1154-1157, IEEE, New York, US; E.G. SUPPA et al.: "Progresses on the ESA-lightweight hybrid solar array"**

(73) Patentinhaber: **ERNO Raumfahrttechnik Gesellschaft mit beschränkter Haftung, Hünefeldstrasse 1-5, D-2800 Bremen 1(DE)**

(72) Erfinder: **Hornung, Ernst, Platanenweg 8, D-2805 Stuhr 1(DE)**
Erfinder: **Rex, Dietrich, Prof. Dr., Rostocker Strasse 36, D-3300 Braunschweig(DE)**

## Beschreibung

Die Erfindung bezieht sich auf einen Sonnenenergiesammler zur Erzeugung elektrischer Energie aus Sonnenstrahlen mit mehreren nebeneinander angeordneten, streifenförmigen Spiegeln, deren Rückseiten Solarzellen tragen und von der konzentrierten Strahlung der Spiegelvorderseiten beaufschlagt werden.

Ein Sonnenenergiesammler dieser Art geht zum Beispiel aus der DE-PS 25 57 296 hervor. Bei diesem Sonnenenergiesammler sind die streifenförmigen Spiegel parabelförmig gekrümmt, so daß sich eine nahezu brennlinienförmige Konzentration der Strahlung für die auf den Spiegelrückseiten angeordneten Solarzellen ergibt. Hierdurch ist es möglich, einen hohen Wirkungsgrad bei der Umsetzung der Sonnenstrahlung in elektrische Energie zu erzielen. Die streifenförmigen Spiegel wirken mit ihren Rückseiten gleichzeitig als Radiatoren, so daß die Solarzellen trotz der konzentrierten Strahlung hinreichend kühl bleiben und den Wirkungsgrad nicht verschlechtern. Es ist daher möglich, eine bestimmte elektrische Leitung mit erheblich weniger Solarzellen als bisher zu erzielen und damit das Leistungsgewicht eines Solarpanels, beispielsweise für Weltraumeinsätze, erheblich zu reduzieren. Unbefriedigend ist aber, daß das Volumen eines solchen Sonnenenergiesammlers relativ groß ist, wodurch teurer Stauraum, vornehmlich bei Weltraumeinsätzen, blockiert wird. Außerdem ist es nachteilig, daß die streifenförmigen Spiegel nur in Verbindung mit einer Verstellung eines Solarpanels zur Strahlungsrichtung verstellbar sind.

Der Erfindung liegt daher die Aufgabe zugrunde, einen Sonnenenergiesammler vorzusehen, der insbesondere für Transportzwecke auf ein geringes Volumen zusammenfaltbar ist. Gleichzeitig ist es Aufgabe der Erfindung, die streifenförmigen Spiegel, unabhängig von der Stellung des Solarpanels, einstellbar zu machen. Diese Aufgabe ist gemäß der Erfindung mit den in Anspruch 1 angegebenen Merkmalen dadurch gelöst, daß die streifenförmigen Spiegel an vier Tragseilen zwischen zwei Traversen schwenkbar aufgehängt und mit zwei Führungsseilen in ihrer Lage, geführt an einem ein- und ausfahrbaren Teleskopmast, befestigt sind.

Die erfindungsgemäße Maßnahme ermöglicht für einen Sonnenenergiesammler einen zusammenklappbaren Aufbau und eine gesonderte Verstellung der streifenförmigen Spiegel, wodurch sich insbesondere für Transportzwecke eine bessere Raumausnutzung und im Einsatz eine bessere Ausrichtung der Spiegel ergibt. Hierbei ist es vorteilhaft, in den Traversen Rollen zum Auf- und Abrollen der Führungsseile und Stellhebel zum Verschwenken der Spiegel vorzusehen. Außerdem ist es zweckmäßig, die Traversen und den Teleskopmast aus faserverstärkten Verbundwerkstoffen herzustellen.

Beim Aufbau eines erfindungsgemäßen Sonnenenergiesammlers ist es weiterhin zweckmäßig, die streifenförmigen Spiegel aus wärmeleitendem Werkstoff herzustellen sowie parabelförmig zu krümmen und die an den Spiegelrückseiten anzubringenden Solarzellen wärmeleitend mit den Spiegeln zu verbinden. Hierdurch wird eine brennlinienartige Konzentration der Lichtstrahlen für die Solarzellen bewirkt. Gleichzeitig ist es sinnvoll, die Rückseiten der streifenförmigen Spiegel derart auszubilden, daß diese den nicht in elektrische Ernergie gewandelten Anteil der Lichtstrahlen abstrahlen.

Für die Spiegel, die auch zu beiden Seiten eines Teleskopmastes angeordnet sein können, ist es vorteilhaft, Aluminiumstreifen von 0,1 bis 0,2 mm Dicke zu verwenden, deren Vorderseiten mit einer Silber- und einer Schutzschicht überzogen und deren Rückseiten anodisiert sind.

Die Erfindung wird anhand der beiliegenden Zeichnung erläutert, und zwar zeigt

Fig. 1 ein Solarpanel in Schrägdarstellung,
Fig. 2a einen ausgefahrenen Sonnenenergiesammler im Prinzip,
Fig. 2b einen eingefahrenen Sonnenenergiesammler im Prinzip,
Fig. 3a bis Fig. 3c drei verschiedene Formen für den Aufbau von Solarpanels und
Fig. 4 einen schematischen Querschnitt durch einen Sonnenenergiesammler.

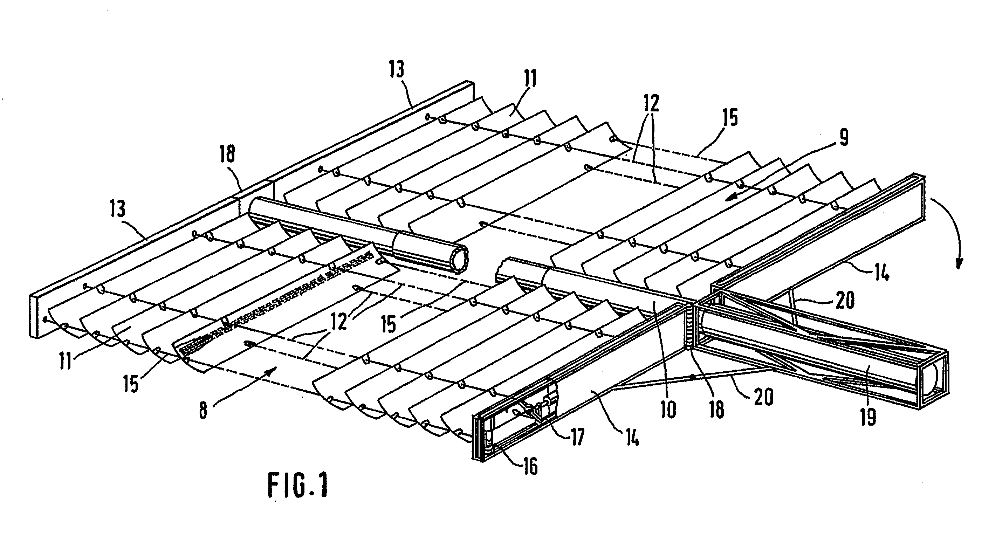

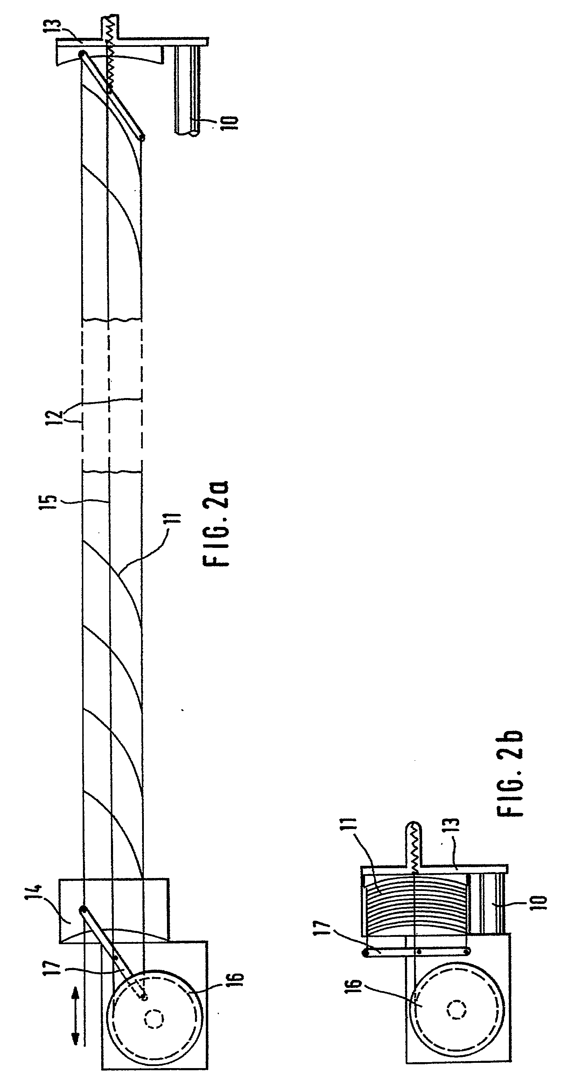

In der Darstellung nach Fig. 1 ist ein Solarpanel dargestellt, der aus zwei zu beiden Seiten eines Teleskopmastes 10 angebrachten Sonnenenergiesammlern 8, 9 besteht. Diese Sonnenenergiesammler 8, 9 bestehen jeweils aus mehreren streifenförmigen Spiegeln 11, die in der Art einer Zugjalousie mit vier Tragseilen 12 an ihren Längsseiten zwischen zwei Traversen 13, 14 aufgehängt sind. Neben den Tragseilen 12 sind die Spiegel 11 mit zwei Führungsseilen 15, und zwar an ihren Querseiten geführt, die ebenfalls in den Traversen 13, 14 enden. Wie die Darstellungen nach Fig. 1 und 2 zeigen, sind in den Traversen Rollen 16 und Hebel 17 vorgesehen, welche eine Einstellung der Spiegel auf das einfallende Sonnenlicht und ein Aus- bzw. Einfahren der Sonnenenergiesammler gestatten.

Fig. 2a zeigt die ausgefahrene und Fig. 2b die eingefahrene Stellung. In Fig. 1 ist weiterhin zu erkennen, daß die Traversen 13, 14 mit Scharnieren 18 am Teleskopmast 10 angebracht sind, so daß es insbesondere in der eingefahrenen Stellung möglich ist, die zusammengefahrenen Sonnenenergiesammler 8, 9 an den Befestigungsstutzen 19 des Teleskopmastes 10 durch Falten von Laschen 20 anzuklappen. Das gesamte Sonnenpanel nimmt daher in der eingefahrenen und zusammengeklappten Stellung gegenüber der ausgefahrenen Stellung nur noch sehr wenig Raum ein.

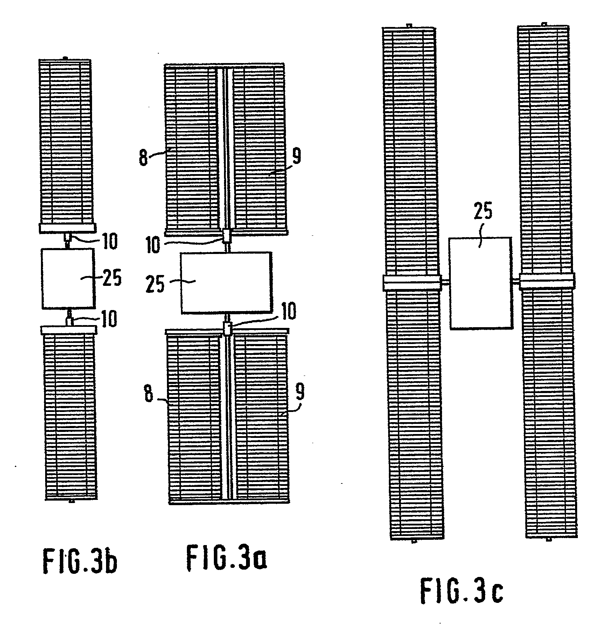

Der erfindungsgemäße Sonnenenergiesammler kann auf verschiedene Weisen zu einem Sonnenpanel aufgebaut werden. So zeigt die Darstellung nach Fig. 3a einen Satelliten 25 mit zwei Sonnenpanels, die dem nach Fig. 1 entsprechen. Fig. 3b zeigt einen weiteren Satelliten 25, zu dessen beiden Seiten jeweils ein nur einen Sonnenenergiesammler umfassendes Sonnenpanel angeordnet ist.

Fig. 3c zeigt einen Satelliten 25 mit jeweils zwei Sonnenpanels, die aus jeweils zwei Sonnenenergiesammlern 8, 9 bestehen. Die Traversen 13, 14 und der Teleskopmast 10 können hierbei in vorteilhafter Weise aus faserverstärktem Verbundwerkstoff bestehen.

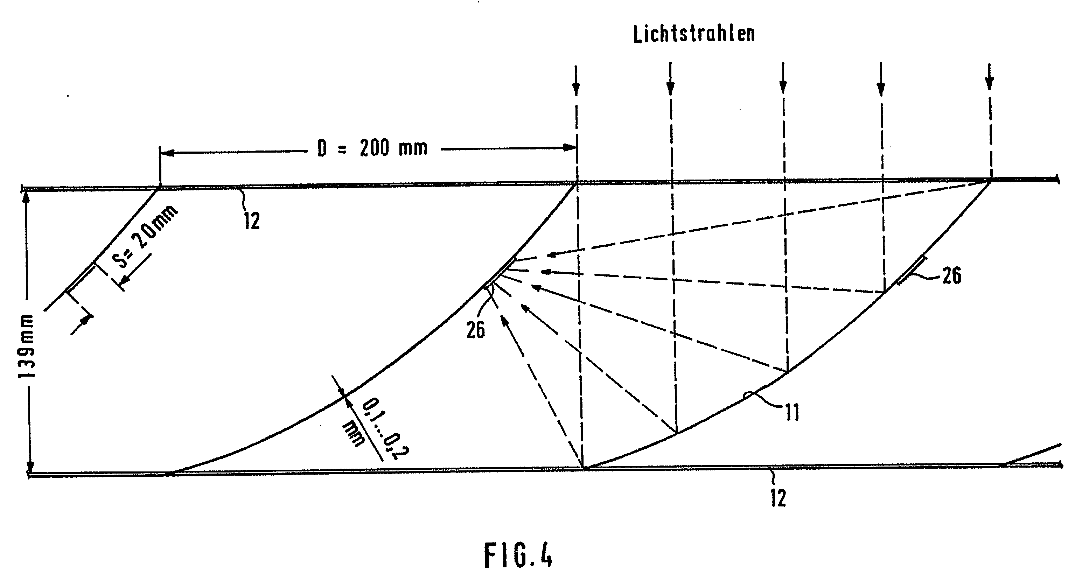

Wie aus der Darstellung nach Fig. 4 hervorgeht, werden die einfallenden Lichtstrahlen von den Spiegelvorderseiten auf die an den Spiegelrückseiten angebrachten Solarzellen 26 konzentriert. Die streifenförmigen Spiegel sind dabei aus einem Aluminiumband von 0,1 mm bis 0,2 mm Dicke hergestellt und auf der Spiegelvorderseite mit einer Silber- und einer Schutzschicht überzogen. Für die Schutzschicht kann vorteilhafterweise Al2O3 benutzt werden. Außerdem ist es zweckmäßig, die Spiegelrückseiten zu anodisieren und die Solarzellen 26 wärmeleitend mit den Spiegeln 11 zu verbinden. Hierdurch wird sichergestellt, daß sich die Solarzellen nicht zu stark erwärmen und der nicht in elektrische Energie umgewandelte Anteil der Sonnenstrahlung von den Spiegelrückseiten wieder abgestrahlt wird.

Der Aufbau des erfindungsgemäßen Sonnenenergiesammlers hat weiter den Vorteil, daß bei einem Einsatz im Weltraum in relativ geringer Höhe die, wenn auch nur in geringem Maße vorhandene Restluft zwischen den Spiegeln durchgelassen wird, um einen sonst auftretenden Staueffekt zu vermeiden, das heißt, den Molekularwiderstand des Sonnenenergiesammlers zu verringern.

**Patentansprüche**

1. Sonnenenergiesammler zur Erzeugung elektrischer Energie aus Sonnenstrahlen mit mehreren nebeneinander angeordneten, streifenförmigen Spiegeln (11), deren Rückseiten Solarzellen (26) tragen und von der konzentrierten Strahlung der Spiegelvorderseiten beaufschlagt werden, dadurch gekennzeichnet, daß die streifenförmigen Spiegel (11) an vier Tragseilen (12) zwischen zwei Traversen (13, 14) schwenkbar aufgehängt und mit zwei Führungsseilen (15) in ihrer Lage geführt sind in der Art einer Zugjalousie und daß die Traversen (13, 14) an den Enden eines ein- und ausfahrbaren Teleskopmastes (10) befestigt und an diesen anklappbar sind.

2. Sonnenergiesammler nach Anspruch 1, dadurch gekennzeichnet, daß in den Traversen (13, 14) Rollen (16) zum Auf- und Abrollen der Führungsseile (15) und Stellhebel (17) zum Verschwenken der streifenförmigen Spiegel (11) mittels der Tragseile (12) vorgesehen sind.

3. Sonnenenergiesammler nach Anspruch 1, dadurch gekennzeichnet, daß die Traversen (13, 14) und der Teleskopmast (10) aus faserverstärkten Verbundwerkstoffen hergestellt sind.

4. Sonnenenergiesammler nach einem der Ansprüche 1 bis 3, dadurch gekennzeichnet, daß die streifenförmigen Spiegel (11) aus wärmeleitendem Werkstoff bestehen und parabelförmig gekrümmt sind und daß die an den Spiegelrückseiten angebrachten Solarzellen (26) wärmeleitend mit den Spiegeln (11) verbunden sind.

5. Sonnenenergiesammler nach einem der Ansprüche 1 bis 4, dadurch gekennzeichnet, daß die Rückseiten der streifenförmigen Spiegel (11) zur Abstrahlung des nicht in elektrische Energie gewandelten Anteils der Sonnenstrahlung ausgebildet sind.

6. Sonnenenergiesammler nach einem der Ansprüche 1 bis 5, dadurch gekennzeichnet, daß zu beiden Seiten eines Teleskopmastes (10) jeweils zwei Spiegelstreifen mit Trag- und Führungsseilen (12, 15) zwischen zwei klappbar angebrachten Traversen (13, 14) angeordnet sind.

7. Sonnenenergiesammler nach einem der vorhergehenden Ansprüche, dadurch gekennzeichnet, daß die streifenförmigen Spiegel (11) aus einem Aluminiumstreifen von ungefähr 0,1 - 0,2 mm Dicke hergestellt sind und daß die Spiegelvorderseite mit einer Silber- und einer Schutzschicht überzogen und die Rückseite anodisiert ist.

**Revendications**

1. Capteur solaire pour générer de l'énergie électrique à partir du rayonnement solaire, comportant plusieurs miroirs (11) en forme de bandes, juxtaposés, dont les faces arrière portent des cellules solaires (26) recevant le rayonnement concentré par les faces avant des miroirs, capteur caractérisé en ce que les miroirs (11) en forme de bandes sont suspendus de manière pivotante sur quatre câbles (12) entre deux traverses (13, 14) et sont guidés en position par deux câbles (15) à la manière d'un store vénitien et en ce que les traverses (13, 14) sont fixées aux extrémités d'un mât télescopique (10) susceptible d'être entré et sorti, en étant basculantes.

2. Capteur solaire selon la revendication 1, caractérisé en ce que les traverses (13, 14) comportent des bobines (16) pour enrouler et dérouler des câbles de guidage (15) et des leviers de réglage (17) pour basculer les miroirs en forme de bandes (11) à l'aide des câbles de support (12).

3. Capteur solaire selon la revendication 1, caractérisé en ce que les traverses (13, 14) et le mât télescopique (10) sont réalisés en des matériaux composites renforcés par des fibres.

4. Capteur solaire selon l'une des revendications 1 à 3, caractérisé en ce que les miroirs (11) en forme de bandes sont réalisés en des matériaux conducteurs de chaleur, courbés suivant une forme parabolique et en ce que les cellules solaires (26) prévues sur les faces arrière des miroirs sont reliées aux miroirs (11) de manière conductrice de chaleur.

5. Capteur solaire selon l'une des revendications 1 à 4, caractérisé en ce que les faces arrière des miroirs en forme de bandes (11) sont conçues pour rayonner la fraction du rayonnement solaire non transformé en énergie électrique.

6. Capteur d'énergie solaire selon l'une des revendications 1 à 5, caractérisé en ce que des deux côtés d'un mât télescopique (10), on a chaque fois deux miroirs en forme de bandes avec des câbles de support et de guidage (12, 15) entre deux traverses (13, 14), suivant un montage basculant.

7. Capteur solaire selon l'une des revendications précédentes, caractérisé en ce que les miroirs en forme de bandes (11) sont réalisés dans des bandes d'aluminium d'une épaisseur comprise entre 0,1 et 0,2 mm et en ce que la face avant des miroirs est revêtue d'argent et d'une couche de protection, la face arrière étant anodisée.

## Claims

1. Solar energy collector for the production of electrical energy from solar radiation with a plurality of strip-like mirrors (11) arranged side by side of which the rear sides carry solar cells (26) and receive the concentrated radiation of the mirror fronts, characterised in that the strip-like mirrors (11) are pivotally suspended from four supporting lines (12) between two cross members (13, 14) and are positionally guided by two guide lines (15) in the manner of a Venetian blind and in that the cross members (13, 14) are fixed to the ends of a retractable and extendable telescopic pole (10) and are foldable relative thereto.

2. Solar energy collector according to claim 1, characterised in that in the cross members (13, 14) there are provided rollers (16) for winding and unwinding the guide lines (15) and control levers for pivoting the strip-like mirrors (11) by means of the supporting lines (12).

3. Solar energy collector according to Claim 1, characterised in that the cross members (13, 14) and the telescopic pole (10) are made from fibre-reinforced composite materials.

4. Solar energy carrier according to any one of Claims 1 to 3, characterised in that the strip-like mirrors (11) consist of heat-conducting material and are parabolically curved and in that the solar cells (26) mounted on the rear sides of the mirrors are connected to the mirrors in a heat conducting manner.

5. Solar energy collector according to any one of Claims 1 to 4, characterised in that the rear sides of the strip-like mirrors (11) are formed for the radiation of the part of solar radiation which is not converted into electrical energy.

6. Solar energy collector according to any one of Claims 1 to 5, characterised in that on both sides of a telescopic pole (10) there are in each case arranged two mirror strips with supporting and guide lines (12, 15) between two foldably-mounted cross members (13, 14).

7. Solar energy collector according to any preceding Claim, characterised in that the strip-like mirrors (11) are made of an aluminium strip of approximately 0.1–0.2 mm thickness and in that the mirror front is coated with a silver layer and a protective layer and the rear side is anodised.

FIG.1

EP 0 218 858 B1

FIG. 2a

FIG. 2b

EP 0 218 858 B1

FIG.3b  FIG.3a

FIG.3c

Lichtstrahlen

D = 200 mm

S = 20mm

12

139mm

26

26

0,1...0,2 mm

11

12

FIG.4

EP 0 218 858 B1